# EUROPEAN PATENT APPLICATION

(11) **EP 1 594 222 A1**
(43) Date of publication of application: **09.11.2005**
(21) Application number: 04360048.5
(22) Date of filing: 07.05.2004
(51) Int. Cl.: H03F 1/02

(54) **Operating point adjusting method and power amplifier circuit**

(71) Applicant: ALCATEL, 75008 Paris (FR)
(72) Inventor: Pascht, Andreas, 73635 Rudersberg (DE); Bohn, Thomas, 70176 Stuttgart (DE)
(74) Representative: Kohler Schmid Möbus

(57) **Abstract**

This invention relates to an operating point adjusting method of a power amplifier 30 of a base station transmit circuit, comprising the step of measuring an output power value of the power amplifier 30 and a power amplifier circuit of a base station transmit circuit comprising an adaptive feedback bias loop and a power detector 36 attached to an output of the power amplifier 30, being designed to measure an output power value of the power amplifier 30. According to the invention bias control values are selected out of bias parameters from a lookup table containing said bias parameters according to said output power value by a bias control stage 34 and said bias control values are applied to a transistor of the power amplifier 30.

## Description

This invention relates to an operating point adjusting method of a power amplifier of a base station transmit circuit, comprising the step of measuring an output power value of the power amplifier and a power amplifier circuit and a transmitter circuit of a base station. Such methods and circuits are used for efficiency improvement of power amplifier chains preferably within UMTS base stations.

Efficiency improvement of power amplifiers is one of the major problems in the analogue transmitter chain of communication systems using bandwidth efficient modulation schemes and multi-carrier operation.
Amplifiers are electronic components which generally exhibit nonlinear behavior, meaning that the output signal is often distorted compared to the input signal. Digital communication systems with non constant envelope modulation are limited by the non-linearities of the power amplifier. This leads to a very poor efficiency of the amplification device. For this reason telecommunication systems include means for linearizing the amplifiers. Methods for the efficiency optimization e.g. digital predistortion are developed.
The method most widely used consists of applying predistortion to the signals upstream of the amplifier input, the predistortion being such that a signal is obtained at the output of the amplifier which faithfully represents the input signal before predistortion is applied. The predistortion can be digital or analogue.

Other existing systems are using a peak to average reduction of the signal (clipping) together with a digital predistortion of the W-CDMA signals to increase the power amplifier efficiency. The biasing of the power amplifier often is fixed in these solutions. Increasing the efficiency of an amplifier by applying a clipping method which consists of limiting the amplitude of the signal at the input of the amplifier to a maximum value are well known in the art. The limit or threshold value (clipping radius) is determined as a function of the most unfavorable case of signals to be transmitted by the transmission system of which the amplifier is part, i.e. as a function of the greatest possible ratio between the peek power and the average power of that signal.

Any distortion or attenuation defect of the signal must conform to the quality and fidelity constrains of the transmission system, which are defined by specific standards. In case of UMTS signals, these constrains are defined by 3GPP standards. 3GPP and 3GPP2 are new world wide standards for the creation, delivery and playback of multimedia via 3rd generation, high-speed wireless networks, for example Wideband Code Division Multiple Access (W-CDMA) systems. Defined by the 3rd Generation Partnership Project and 3rd Generation Partnership Project 2 respectively, these standards seek to provide uniform delivery of multimedia over newly evolved, broadband mobile networks (3rd generation networks) to the latest multimedia-enabled wireless devices. According to these standards an Adjacent Channel Leakage Power (ACLR) is defined as the ratio of a transmitted power to a power measured after a receiver filter in the adjacent channel. According to said standards this ACLR must not exceed specific values to meet the requirements of the standards.
The power amplifier, e.g. of an UMTS base station, is used in class-A operation for best linearity amplification. Both techniques, clipping and predistortion, usually are using a fixed power amplifier biasing. Therefore, the power amplifier current is very high. This causes a poor efficiency. To optimize the efficiency the operation point (biasing) of the power amplifier has to be adapted. The problem of these techniques is the fixed power amplifier operating point.

In the United States patent application publications US 2003/0091123A1 or US 2003/0092462A1 methods for optimizing the efficiency of power amplifiers are described, wherein the operating point of a power amplifier is adopted according to power estimates provided by power estimation devices. The power estimates depend on the input signal of different transmitting channels of the amplifier. Furthermore, the rate of change of the operating point of the amplifier is conditioned according to a state of convergence of predistortion parameters, selected according to an output power value of the amplifier, which is measured by an output power measuring unit. Predistortion parameters and operating point parameters are conditioned in a control loop.

A disadvantage of this method is the fact that the convergence time of the control loop depends on the quality of the power estimation. This fact might affect the usability of the methods, because the control loop might be unstable if the estimation fails to be sufficiently correct. Furthermore, the method is complicated because of the power estimation and the bias parameter adoption using a control loop. Therefore, an electronic circuit implementing the method is expensive to produce.

It is therefore an object of the invention to provide an operation point adjusting method of a base station transmit circuit and a power amplifier circuit of a base station transmit circuit which overcome the problems associated with the related art, in particular which enable a fast and secure adoption of the operating point of the amplifier.

The object concerning the data authentication method is attained by the operating point adjusting method defined in claim 1 and the object concerning the power amplifier circuit is attained by the power amplifier circuit according to claim 4.

Further advantageous features of the invention are defined in the depending claims.

The inventive operating point adjusting method of a power amplifier of a base station transmit circuit is comprising the step of measuring an output power value of the power amplifier. According to the invention bias control values are selected out of bias parameters from a lookup table containing said bias parameters according to said output power value by a bias control stage and said bias control values are applied to a transistor of the power amplifier. According to the power value of an amplified signal measured at the output of the power amplifier, i.e. the transistor, a bias control function selects a pre-defined set of bias parameters for the power amplifier transistor. This set of pre-defined parameter values for the transistor have been previously calculated and/or measured as optimal bias control values for given operating conditions and introduced as a table in a memory of the bias control stage. The inventive method may be applied several times again, preferably in a control loop, if necessary to adopt the bias control values optimally.

The inventive method results at least in the following advantages:
- Improved power amplifier efficiency by adaptive bias control, without having convergence problems
- An adaptive bias control of the power amplifier is performed whereby the amplifier current (I_{D}) is reduced.
- Shop cost reduction of the power amplifier chain is achieved due to optimized efficiency.
- Optimized thermal conditions within a base station rack because of lower I_{D}.
- The output power of the base station transmit circuit is increased.
- Higher integration of the transmit module due to an optimized power amplifier chain is made possible.
- Only very little additional hardware is required for the adaptive bias control.

Preferably, said bias parameters are pre-defined Gate-Source voltage (V_{GS}) values and/or Drain-Source voltage (V_{DS}) values depending on output power values and said bias control values are applied to said transistor as bias voltage values. The lookup table is containing a number of output power values and respective V_{GS} and/or V_{DS} values. It is preferred to apply Gate-Source voltages and/or Drain-Source voltages because those voltages are more easily to be controlled instead of e.g. electric current values for biasing a transistor.

Advantageously, clipping and/or predistortion of signals to be amplified are performed according to said output power value before said signals are amplified. Therefore, the advantages of known linearization and/or efficiency improvement methods are achieved additionally to the advantages of the inventive method.

An inventive power amplifier circuit of a base station transmit circuit is comprising an adaptive feedback bias loop and a power detector attached to an output of the power amplifier, being designed to measure an output power value of the power amplifier. According to the invention the adaptive feedback bias loop is comprising a bias control stage, wherein an output of said power detector is connected to said bias control stage and at least one output of said bias control stage is connected to a transistor of the power amplifier. Furthermore, said bias control stage is comprising memory means, having stored a lookup table containing bias parameters and said bias control stage is being designed to select bias control values from said lookup table according to said output power value and to apply said bias control values to said transistor.

The inventive power amplifier circuit of a base station transmit circuit is designed to perform the steps of the inventive method. Therefore, it makes available the advantages being provided by the inventive method.

Advantageously, said bias parameters are pre-defined Gate-Source voltage values and Drain-Source voltage values depending on output power values and a first output of said outputs of said bias control stage is being designed to apply a Gate-Source voltage selected as a bias control value to Gate-Source terminations of said transistor and a second output of said outputs of said bias control stage is being designed to apply a Drain-Source voltage selected as a bias control value to Drain-Source terminations of said transistor. Therefore, the hardware effort to measure and control the bias parameters is smaller compared to other bias parameters, e.g. different electric currents of the transistor.

In another preferred embodiment of the invention, the inventive power amplifier circuit is comprising a feedback path loop, being designed to perform a clipping and/or predistortion of signals to be amplified according to said output power value before said signals are amplified. Due to the fact that predistortion and the necessity of clipping depends on the characteristics of the used transistor of the amplifier and the adjustment of its bias parameters, the advantages of this known linearization and/or efficiency improvement methods are optimally achieved if the clipping and/or predistortion of signals is carried out depending on the output power value of the transistor.

Advantageously, said bias control stage of the inventive power amplifier circuit is comprising a digital processing unit, i.e. a microprocessor, preferably a Field Programmable Gate Array (FPGA) or a Digital Signal Processor (DSP). Said processing unit is carrying out the steps of selecting bias control values out of bias parameters from a lookup table containing said bias parameters according to said output power value and applying said bias control values to the transistor of the power amplifier. To implement those steps of the inventive method as a computer program and to load said computer program in a Digital Signal Processor DSP being part of the bias control stage is the most appropriate, especially cheapest and fastest way to implement the inventive method.

The inventive power amplifier circuit is preferably implemented as a part of a transmitter circuit, which preferably is a part of a base station of a telecommunication system.

The different features of the preferred embodiments of the invention may be used in combination together with the invention as set forth in the independent claims or just each single preferred embodiment together with the invention as set forth in the independent claims.

The embodiments of the invention will now be described with reference to the accompanying drawing.

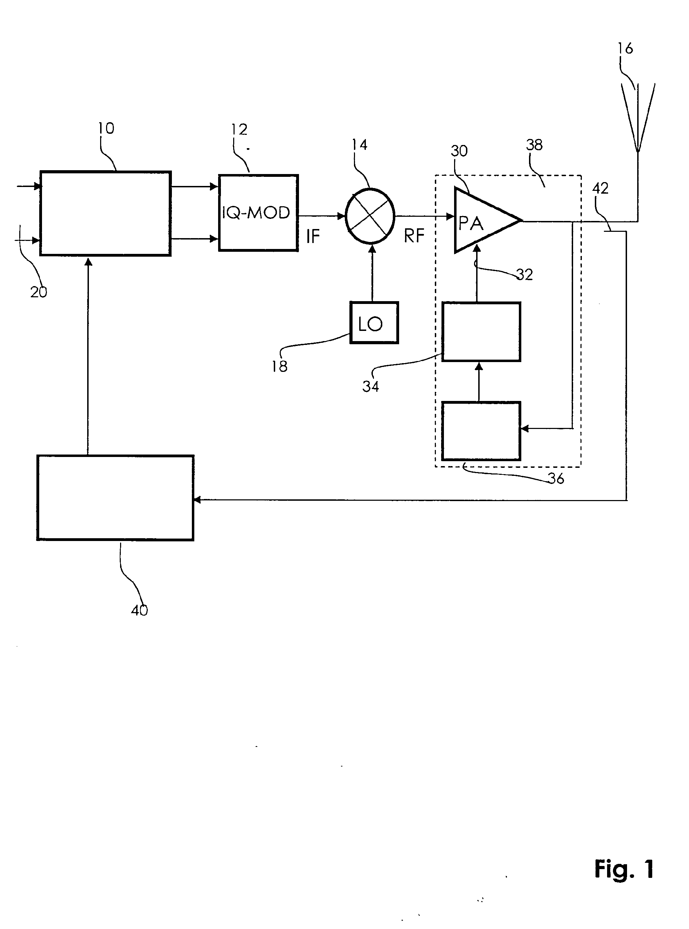

In figure 1 the transmit chain of a UMTS base station is shown schematically as an example of an inventive power amplifier. According to the invention the bias control stage 34 is used to select the parameter set to control the biasing of the power amplifier 30, i.e. a transistor of the power amplifier. Equally, the parameter set can be selected by the power detector itself, meaning the power detector and the bias control stage 34 can be implemented as one. The output power of the power amplifier 30 is measured and according to the value of the output power an adaptation of the biasing is performed to reduce the amplifier current which increases the efficiency. The power amplifier circuit of a base station transmit circuit is comprising an adaptive feedback bias loop 38 and a power detector 36 attached to an output of the power amplifier 30, being designed to measure an output power value of the power amplifier 30 before the amplified signal is being transmitted using an antenna 16. The adaptive feedback bias loop is comprising a bias control stage 34. An output of said power detector 36 is connected to said bias control stage 34 and at least one output 32 of said bias control stage 34 is connected to a transistor of the power amplifier 30. The bias control stage 34 is comprising memory means, having stored a lookup table containing bias parameters and said bias control stage 34 is being designed to select bias control values from said lookup table according to said output power value and to apply said bias control values to said transistor. The bias control stage selects a pre-defined set of bias parameters, e.g. the voltage values V_{GS} and/or V_{DS} according to the output power value measured and applies said voltage values to the power amplifier transistor. The transmit chain as shown further is comprising a feedback path loop 40, being designed to perform a clipping and/or predistortion of signals to be amplified according to said output power value before said signals are amplified. Both techniques can be used in addition to the invention to optimize the power amplifier efficiency.
The output power value, according to which the clipping and/or predistortion is controlled, also can be achieved using an outcoupling device 42, being designed to couple out a part of the amplified signal before the amplified signal is being transmitted using an antenna 16.
In the example two signals are being processed simultaneously. The predistortion and/or clipping of the two signals to be amplified and transmitted is being done by a predistortion and/or clipping module 10. The signals from Basband are fed into an input 20, having an input channel for each signal, of the predistortion and/or clipping module 10. After predistortion and/or clipping have been applied to each of the signals an In-Phase Squaring Modulation (IQ-Mod) of the signals is performed. The two signals are having a phase shift of 90 degrees against each other. By performing the IQ-Modulation the two signals are being transformed into a single signal having an Intermediate Frequency (IF), which is being provided at an output of the IQ-Modulation module 12. The IF-Signal is fed into a frequency Mixer 14, which increases the frequency of the signal by a frequency of a Local Oszillator (LO) 18. The resulting signal is having a Radio Frequency (RF). This RF-Signal is being amplified by the amplifier 30. The power detector 36 of the adaptive feedback bias loop 38 is attached to the output of the power amplifier 30. The output of the power amplifier is connected to the bias control block 34. Said bias control block 34 is comprising memory means with a table containing a set of predefined bias control values tabulated over output power values of the power amplifier (Power value →VGS, VDS). Preferably, the control block 34 is having two outputs, a first output for applying a voltage between the Gate-Source terminations of the power amplifier transistor, and a second output for applying a voltage between the Drain-Source terminations of the power amplifier transistor.
The inventive method is based on a power measurement at the output of the power amplifier. This power measurement is done within the power amplifier chain. The output data of the power measurement is used to select a pre-defined set of bias parameters stored in the bias control stage or block. The bias parameters consist of V_{GS} (Gate-Source-Voltage of the device) and V_{DS} (Drain-Source-Voltage of the device). The two voltages are used to bias the device. This allows an adaptive biasing control of the device and an optimized Drain current (I_{D}) consumption. This results in an optimized efficiency of the power amplifier.
The following table is an example of a lookup table according to the invention, containing bias control values in dependence of the measured output power:

| Measured Output Power [Watt] | Gate Source Voltage [Volt] | Drain Source Voltage [Volt] |
|---|---|---|
| 40 | 6 | 28 |
| 35 | 5,5 | 28,5 |
| 30 | 5 | 29 |

This invention relates to an operating point adjusting method of a power amplifier 30 of a base station transmit circuit, comprising the step of measuring an output power value of the power amplifier 30 and a power amplifier circuit of a base station transmit circuit comprising an adaptive feedback bias loop and a power detector 36 attached to an output of the power amplifier 30, being designed to measure an output power value of the power amplifier 30. According to the invention bias control values are selected out of bias parameters from a lookup table containing said bias parameters according to said output power value by a bias control stage 34 and said bias control values are applied to a transistor of the power amplifier 30.

## Claims

1. An operating point adjusting method of a power amplifier (30) of a base station transmit circuit, comprising the step of
- measuring an output power value of the power amplifier (30),
**characterized in that**
bias control values are selected out of bias parameters from a lookup table containing said bias parameters according to said output power value by a bias control stage (34) and said bias control values are applied to a transistor of the power amplifier (30).

2. The method according to claim 1, **characterised in that** said bias parameters are pre-defined Gate-Source voltage values and/or Drain-Source voltage values depending on output power values and said bias control values are applied to said transistor as bias voltage values.

3. The method according to claim 1, **characterised in that** clipping and/or predistortion of signals to be amplified are performed according to said output power value before said signals are amplified.

4. A power amplifier circuit of a base station transmit circuit comprising an adaptive feedback bias loop and a power detector (36) attached to an output of the power amplifier (30), being designed to measure an output power value of the power amplifier (30),
**characterized in that**
the adaptive feedback bias loop is comprising a bias control stage (34), wherein an output of said power detector (36) is connected to said bias control stage (34) and at least one output of said bias control stage (34) is connected to a transistor of the power amplifier (30), and
wherein said bias control stage (34) is comprising memory means, having stored a lookup table containing bias parameters and
wherein said bias control stage (34) is being designed to select bias control values from said lookup table according to said output power value and to apply said bias control values to said transistor.

5. The power amplifier circuit according to claim 4, **characterised in that** said bias parameters are pre-defined Gate-Source voltage values and Drain-Source voltage values depending on output power values and a first output of said outputs of said bias control stage is being designed to apply a Gate-Source voltage selected as a bias control value to Gate-Source terminations of said transistor and a second output of said outputs of said bias control stage is being designed to apply a Drain-Source voltage selected as a bias control value to Drain-Source terminations of said transistor.

6. The power amplifier circuit according to claim 4, **characterised in that** the power amplifier is comprising a feedback path loop, being designed to perform a clipping and/or predistortion of signals to be amplified according to said output power value before said signals are amplified.

7. The power amplifier circuit according to claim 4, **characterised in that** said bias control stage is comprising a micro processor, preferably a Field Programmable Gate Array (FPGA) or a Digital Signal Processor (DSP).

8. A transmitter circuit comprising the circuit of claim 4.

9. A base station comprising the transmitter of claim 8.
